(19) Europäisches Patentamt
European Patent Office
Office européen des brevets

(11) **EP 1 187 315 B1**

(12) **EUROPÄISCHE PATENTSCHRIFT**

(45) Veröffentlichungstag und Bekanntmachung des Hinweises auf die Patenterteilung:
**17.05.2006  Patentblatt 2006/20**

(51) Int Cl.:
***H03F 3/72*** *(2006.01)*

(21) Anmeldenummer: **01118528.7**

(22) Anmeldetag: **01.08.2001**

(54) **Schaltbarer Operationsverstärker für Switched-Opamp-Anwendungen**

Switchable operational amplifier for switched-opamp-applications

Amplificateur opérationnel commutable pour applications dans un amplificateur opérationnel de commutation

(84) Benannte Vertragsstaaten:
**DE FR GB**

(30) Priorität: **18.08.2000  DE 10040399**

(43) Veröffentlichungstag der Anmeldung:
**13.03.2002  Patentblatt 2002/11**

(73) Patentinhaber: **Infineon Technologies AG**
**81669 München (DE)**

(72) Erfinder:
• **Sauerbrey, Jens**
  **82024 Taufkirchen (DE)**
• **Wittig, Martin**
  **27751 Delmenhorst (DE)**

(74) Vertreter: **Lange, Thomas et al**
**Patentanwälte**
**Lambsdorff & Lange**
**Dingolfinger Strasse 6**
**81673 München (DE)**

(56) Entgegenhaltungen:
**EP-A- 0 899 871          US-A- 3 541 466**
**US-A- 6 107 883**

• **WALTARI M ET AL: "A switched-opamp with fast common mode feedback" ELECTRONICS, CIRCUITS AND SYSTEMS, 1999. PROCEEDINGS OF ICECS '99. THE 6TH IEEE INTERNATIONAL CONFERENCE ON PAFOS, CYPRUS 5-8 SEPT. 1999, PISCATAWAY, NJ, USA,IEEE, US, 5. September 1999 (1999-09-05), Seiten 1523-1525, XP010361867 ISBN: 0-7803-5682-9**

**Beschreibung**

Die Erfindung betrifft einen schaltbaren Operationsverstärker für die Switched-Opamp-Technik, sowie ein Verfahren zum Betrieb eines derartigen Operationsverstärkers.

Die Switched-Opamp-Technik hat sich aus der Switched-Capacitor-Technik heraus entwickelt, um dem Bedürfnis nach immer niedrigeren Versorgungsspannungen entsprechen zu können. Bei der Switched-Opamp-Technik werden nicht nur die Kapazitäten, sondern auch die Operationsverstärker selbst durch ein Schaltsignal periodisch ein- und ausgeschaltet. Da jeder Operationsverstärker während ca. 50% der Betriebszeit ausgeschaltet ist, kann mit der Switched-Opamp-Technik eine erhebliche Leistungseinsparung realisiert werden. Die Switched-Opamp-Technik eignet sich insbesondere für Anwendungen, bei denen es auf eine niedrige Versorgungsspannung und eine geringe Leistungsaufnahme ankommt, also beispielsweise für Filter und Wandler in Mobilfunkgeräten, für medizinische Einsatzzwecke (Herzschrittmacher, Hörgeräte), etc.

Für den Einsatz in Switched-Opamp-Schaltungen sind schaltbare Operationsverstärker bekannt, bei denen sich die Endstufe mittels eines zusätzlichen Transistors periodisch ein- und ausschalten läßt.

Die Publikation WALTARI M ET AL: "A switched-opamp with fast common mode feedback" ELECTRONICS, CIRCUITS AND SYSTEMS, 1999. PROCEEDINGS OF ICECS '99. THE 6TH IEEE INTERNATIONAL CONFERENCE ON PAFOS, CYPRUS 5-8 SEPT. 1999, PISCATAWAY, NJ, USA,IEEE, US, 5. September 1999 (1999-09-05), Seiten 1523-1525, ISBN: 0-7803-5682-9 offenbart beispielsweise eine solche Schaltungsanordnung.

Demgegenüber liegt der Erfindung die Aufgabe zugrunde, einen schaltbaren Operationsverstärker für die Switched-Opamp-Technik sowie ein Verfahren zum Betrieb eines derartigen Operationsverstärker zu schaffen, welche eine weitere Verringerung der Leistungsaufnahme von Switched-Opamp-Schaltungen ermöglichen.

Diese Aufgabe wird durch einen schaltbaren Operationsverstärker gemäß Anspruch 1 sowie durch ein Verfahren zum Betrieb eines schaltbaren Operationsverstärkers gemäß Anspruch 9 gelöst.

Der erfindungsgemäße schaltbare Operationsverstärker weist eine Vorstufe sowie eine Endstufe auf, wobei die Endstufe durch ein Schalttaktsignal periodisch ein- und ausschaltbar ist. Der erfindungsgemäße schaltbare Operationsverstärker weist Mittel zur Reduzierung des Stroms durch die Vorstufe auf, welche den durch die Vorstufe fließenden Strom während der Aus-Phase des Schalttaktsignals von einem ersten Wert auf einen kleineren zweiten Wert herabsetzen.

Während der Aus-Phase des Schalttaktsignals wird nicht nur der Strom durch die Endstufe abgeschaltet, sondern zusätzlich auch der Strom durch die Vorstufe abgesenkt. Durch diese Maßnahme kann eine zusätzliche Leistungsersparnis gegenüber den bekannten schaltbaren Operationsverstärkern erzielt werden, bei denen die Vorstufe auch während der Aus-Phase des Schalttaktsignals eingeschaltet bleibt und daher ständig Strom verbraucht. Zur Steuerung der periodischen Variation des Stroms durch die Vorstufe kann dasselbe Schalttaktsignal verwendet werden, das auch die Endstufe periodisch ein- und ausschaltet. Daher läßt sich die erfindungsgemäße Lösung mit geringem zusätzlichen Schaltungsaufwand realisieren.

Gemäß einer vorteilhaften Ausführungsform der Erfindung schalten die Mittel zur Reduzierung des Stroms durch die Vorstufe den durch die Vorstufe fließenden Strom während der Aus-Phase des Schalttaktsignals ab. Die vollständige Abschaltung der Vorstufe während der Aus-Phase des Schalttaktsignals stellt die einfachste und kostengünstigste Ausführungsform der Erfindung dar. Mit dieser Lösung kann die höchstmögliche Leistungseinsparung erzielt werden.

Dabei ist es von Vorteil, wenn die Mittel zur Reduzierung des Stroms durch die Vorstufe mindestens einen Transistor umfassen, der den durch die Vorstufe fließenden Strom während der Aus-Phase des Schalttaktsignals abschaltet. Zur Realisierung der Erfindung genügt ein zusätzlicher Transistor, der durch das Schalttaktsignal getaktet wird und die Vorstufe periodisch ein- und ausschaltet. Der Aufwand an zusätzlichen Bauteilen kann bei dieser Ausführungsform also sehr gering gehalten werden.

Gemäß einer alternativen Ausführungsform der Erfindung umfassen die Mittel zur Reduzierung des Stroms durch die Vorstufe mindestens ein Paar parallel geschalteter Transistoren. Während der Einschaltphase des Schalttakts fließt ein erster Bruchteil des durch die Vorstufe fließenden Stroms durch die jeweiligen ersten Transistoren des Paars bzw. der Paare, und ein zweiter Bruchteil des durch die Vorstufe fließenden Stroms fließt durch die jeweiligen zweiten Transistoren des Paars bzw. der Paare. Der Gesamtstrom durch die Vorstufe wird also dergestalt gesplittet, daß ein Teil des Stroms durch die ersten Transistoren und der restliche Teil des Stroms durch die zweiten Transistoren des Paars bzw. der Paare fließt. Während der Aus-Phase des Schalttaktsignals werden dann die jeweiligen zweiten Transistoren abgeschaltet. Dadurch wird der durch die Vorstufe fließende Gesamtstrom auf den durch die ersten Transistoren fließenden ersten Bruchteil reduziert.

Die über die jeweiligen Transistoren fließenden Stromanteile hängt vom Verhältnis W/L, also dem Verhältnis von Breite zu Länge, der verwendeten Devices ab. Auf diese Weise kann eingestellt werden, welcher Bruchteil des Gesamtstroms während der Aus-Phase des Schalttaktsignals abgeschaltet wird. Die über die ersten Transistoren und über die zweiten Transistoren fließenden Ströme können aber auch durch die am Gate der Schalt-FETs anliegende Bias-Spannung eingestellt werden.

Das Aufsplitten des Gesamtstroms hat den Vorteil, daß auch während der Aus-Phase des Schalttaktsignals ein gewisser Stromfluß durch die Vorstufe aufrechterhalten wird. Verglichen mit der völligen Abschaltung der Vorstufe kann dadurch ein besseres Einschaltverhalten erzielt werden. Bei höheren Schaltungsanforderungen ist es daher vorteilhaft, den Strom durch die Vorstufe nicht völlig abzuschalten. Bei entsprechend kleiner Dimensionierung des während der Aus-Phase fließenden Stroms ist die Leistungseinsparung immer noch beträchtlich.

Gemäß einer weiteren vorteilhaften Ausführungsform der Erfindung ist die Vorstufe als gefaltete Vorstufe mit einem Eingangszweig und einem Ausgangszweig ausgeführt. Während der Aus-Phase des Schalttaktsignals setzen die Mittel zur Reduzierung des Stroms durch die Vorstufe den im Eingangszweig fließenden Strom und/oder den im Ausgangszweig fließenden Strom herab.

Der Einsatz einer gefalteten Vorstufe mit einem Eingangszweig und einem Ausgangszweig ist insbesondere bei niedrigen Versorgungsspannungen vorteilhaft. Die im Eingangszweig auftretende Stromdifferenz wird 1:1 auf den Ausgangszweig übertragen. Mit einer gefalteten Vorstufe läßt sich auch bei niedriger Versorgungsspannung ein hoher Signalhub am Ausgang der Vorstufe erzielen.

Bei einer gefalteten Vorstufe kommt es sowohl zu einem Stromfluß im Eingangszweig der Vorstufe als auch zu einem Stromfluß im Ausgangszweig der Vorstufe. Wenn nun das erfindungsgemäße Prinzip einer Stromreduzierung während der Aus-Phase des Schalttakts auf eine gefaltete Vorstufe angewendet wird, dann kann entweder der im Eingangszweig der Vorstufe fließende Strom oder der im Ausgangszweig der Vorstufe fließende Strom herabgesetzt werden. Die höchste Leistungseinsparung wird erzielt, wenn in beiden Zweigen der Strom reduziert wird.

Dazu ist es von Vorteil, wenn der Eingangszweig der Vorstufe mindestens ein Paar parallel geschalteter Transistoren umfaßt, wobei während der Einschaltphase des Schalttaktsignals ein erster Bruchteil des durch den Eingangszweig fließenden Stroms durch die jeweiligen ersten Transistoren des Paars bzw. der Paare fließt, und ein zweiter Bruchteil des durch den Eingangszweig fließenden Stroms durch die jeweiligen zweiten Transistoren des Paars bzw. der Paare fließt. Während der Einschaltphase des Schalttaktsignals wird der Gesamtstrom durch den Eingangszweig also so aufgesplittet, daß ein erster Bruchteil über die ersten Transistoren und ein zweiter Bruchteil über die zweiten Transistoren fließt. Während der Aus-Phase des Schalttaktsignals sind die jeweiligen zweiten Transistoren abgeschaltet. Dadurch wird der Gesamtstrom durch den Eingangszweig während der Aus-Phase um den zweiten Bruchteil verringert bzw. auf den ersten Bruchteil eingeschränkt. Die Höhe des ersten Bruchteils sowie des zweiten Bruchteils des Gesamtstroms kann durch das Verhältnis W/L der verwendeten Transistoren sowie über die jeweilige am Gate der Schalttransistoren anliegende Bias-Spannung eingestellt werden.

Entsprechend ist es von Vorteil, wenn der Ausgangszweig der Vorstufe mindestens ein Paar parallel geschalteter Transistoren umfaßt, wobei der Gesamtstrom durch den Ausgangszweig während der Einschaltphase des Schalttakts wieder in einen ersten Bruchteil und einen zweiten Bruchteil aufgesplittet wird. Der erste Bruchteil fließt durch die jeweiligen ersten Transistoren und der zweite Bruchteil durch die jeweiligen zweiten Transistoren des Paars bzw. der Paare. Während der Aus-Phase des Schalttaktsignals werden die jeweiligen zweiten Transistoren ausgeschaltet, um den Gesamtstrom durch den Ausgangszweig der Vorstufe herabzusetzen.

Gemäß einer weiteren vorteilhaften Ausführungsform der Erfindung setzen die Mittel zur Reduzierung des Stroms durch die Vorstufe den durch die Vorstufe fließenden Strom bereits vor Beginn der Einschaltphase des Schalttaktsignals von dem kleineren zweiten Wert auf den ersten Wert herauf. Bei dieser Lösung werden Vor- und Endstufe nicht mehr synchron getaktet. Statt dessen sind separate Schalttaktsignale für die Vorstufe und die Endstufe vorgesehen. Dadurch ist ein gestuftes Ein-und Ausschalten der Vorstufe und der Endstufe des Operationsverstärkers möglich, und bei geeigneter Abstimmung der Schalttaktsignale kann das Einschalt- und Einschwingverhalten verbessert werden.

Nachfolgend wird die Erfindung anhand mehrerer in der Zeichnung dargestellter Ausführungsbeispiele weiter beschrieben. Es zeigen:

Fig. 1   eine aus dem Stand der Technik bekannte Vorstufe eines Operationsverstärkers;

Fig. 2   eine aus dem Stand der Technik bekannte Endstufe eines Operationsverstärkers für die Switched-Opamp-Technik;

Fig. 3   eine gemäß der Erfindung modifizierte Vorstufe eines Operationsverstärkers für die Switched-Opamp-Technik;

Fig. 4   eine gefaltete Vorstufe eines Operationsverstärkers gemäß dem Stand der Technik;

Fig. 5   eine entsprechend der Erfindung modifizierte gefaltete Vorstufe eines Operationsverstärkers für die Switched-Opamp-Technik.

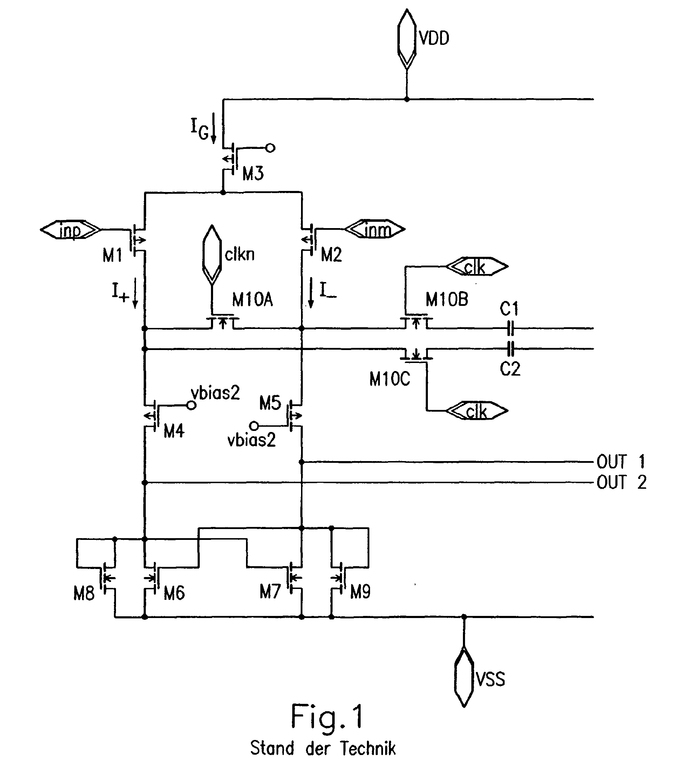

In Fig. 1 ist die Schaltung der Vorstufe eines Operationsverstärkers dargestellt. Das Gate des p-MOSFETs M1 stellt den nicht invertierenden Eingang des Operationsverstärkers dar; an diesem Eingang liegt das Signal inp an. Entsprechend stellt das Gate des p-MOSFET M2 den invertierenden Eingang des Operationsverstärkers dar, an dem das Signal inm anliegt.

Das Device M3, an dessen Gate die konstante Vorspannung vbias1 anliegt, wirkt als Konstantstromquelle. Entsprechend der Spannungsdifferenz der beiden an den Eingängen anliegenden Signale inp und inm teilt sich der Gesamtstrom $I_G$ in die beiden Teilströme $I_+$ und $I_-$ auf. Je größer die Differenz der Eingangssignale inp und inm ist, desto stärker unterscheiden sich die Ströme $I_+$ und $I_-$.

Mittels der Kaskodestufe, welche die Transistoren M4 und M5 umfaßt, und der aus den Devices M6 bis M9 bestehenden aktiven Last werden die beiden Ströme $I_+$ und $I_-$ in die beiden Spannungssignale OUT1 und OUT2 umgewandelt. Die Beschaltung der FETs M6 bis M9 bewirkt, daß die Last für das Gleichtaktsignal nur einen geringen Widerstand, für das Differenzsignal aber einen sehr großen Widerstand aufweist. Dadurch bewirkt eine geringe Änderung des Differenzstroms eine starke Änderung der an den Ausgängen OUT1 und OUT2 anliegenden Spannungen.

Dieser Effekt wird durch die Kaskodestufe noch verstärkt. Die Kaskodestufe umfaßt die beiden p-Typ MOSFETs M4 und M5, an deren Gate jeweils die Bias-Spannung vbias2 anliegt. Eine Kaskodestufe bewirkt eine Erhöhung des Widerstands. Diese Widerstandserhöhung bewirkt, daß kleine Stromänderungen dI in große Spannungsänderungen dU umgesetzt werden. Eine geringfügige Änderung der Ströme $I_+$ und $I_-$ führt entsprechend zu starken Schwankungen der an den Ausgängen OUT1 und OUT2 anliegenden Spannungen. Mittels der Kaskodestufe und der nichtlinearen Last kann daher eine hohe Spannungsverstärkung in der Vorstufe erzielt werden.

Der FET M10A dient zum Schutz der Vorstufe vor Sättigung. Die FETs M10B, M10C verhindern während der Ausschaltphase eine Entladung der Kondensatoren C1, C2, damit das Einschwingverhalten nicht beeinträchtigt wird.

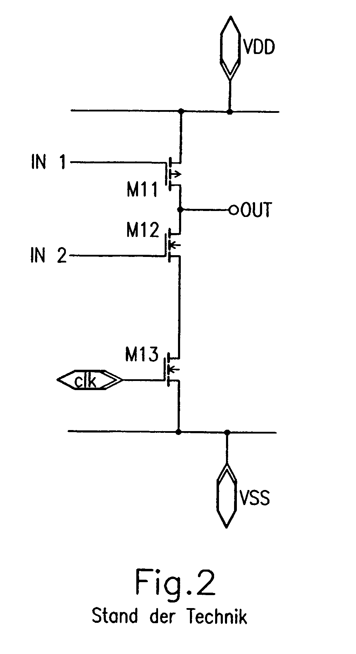

Bei den aus dem Stand der Technik bekannten Operationsverstärkern für die Switched-Opamp-Technik ist die Vorstufe permanent eingeschaltet, während die Endstufe durch das Schalttaktsignal periodisch ein- und ausgeschaltet wird. Fig. 2 zeigt den Schaltplan einer derartigen Endstufe. Der n-Typ FET M13 wird durch das Schalttaktsignal clk getaktet. Solange das Schalttaktsignal clk auf 1 ist, leitet das Device M13, während es in den Aus-Phasen des Schalttaktsignals sperrt. Den Gates der beiden FETs M11 und M12 werden die Eingangsspannungssignale IN1 und IN2 zugeführt. Im eingeschalteten Zustand der Endstufe wirken die beiden Devices M11 und M12 als Spannungsteiler und teilen die Versorgungsspannung VDD in Abhängigkeit von den Eingangsspannungssignalen. Am Ausgang der Endstufe erscheint das Ausgangsspannungssignal OUT. Während der Aus-Phase des Schalttakts ist das Signal OUT hochohmig oder liegt auf VDD, da durch M13 der Strompfad zu VSS aufgetrennt ist.

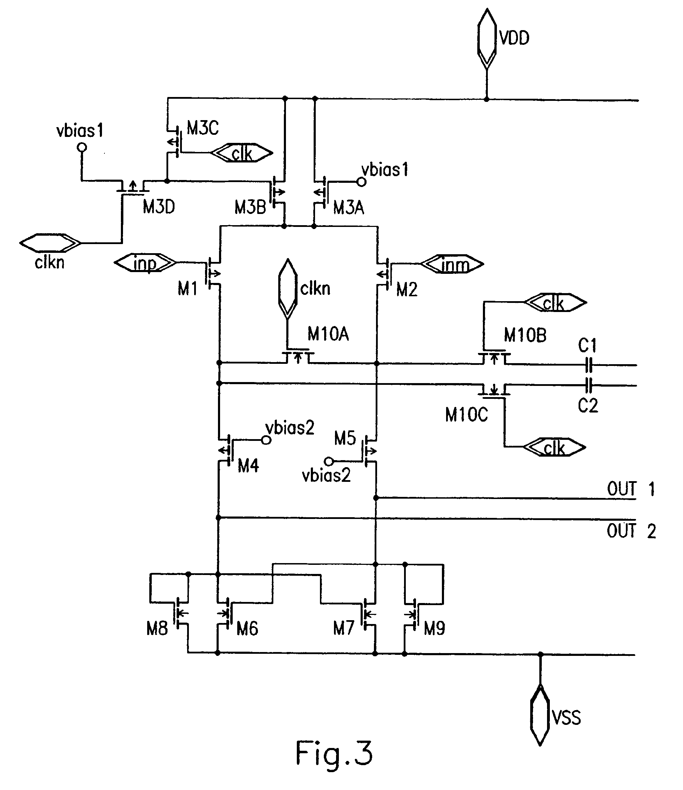

In Fig. 3 ist eine Vorstufe dargestellt, bei der das erfindungsgemäße Prinzip verwirklicht ist, den Vorstufenstrom während der Ausschaltphase des Schalttakts herabzusetzen. Zu diesem Zweck sind zwei parallelgeschaltete p-MOSFETs M3A und M3B vorgesehen. Über das Device M3A fließt sowohl während der Einschalt- als auch während der Ausschaltphase ein konstanter Strom. Zum strombegrenzenden Device M3A ist ein weiteres Device vom p-Typ M3B parallel geschaltet, das während der Einschaltphasen des Schalttakts einen Beitrag zum Gesamtstrom $I_G = I_+ + I_-$ liefert.

Während der Einschaltphase des Schalttakts liegt das Schalttaktsignal clk auf 1, während sich das invertierte Schalttaktsignal clkn auf 0 befindet. Während der Einschaltphase sperrt daher das p-Device M3C, während das p-Device M3D leitet. Das Gate des strombegrenzenden p-MOSFETs M3B ist daher über das Device M3D mit der Spannung vbias1 verbunden, und der FET M3B leitet. Daher fließt während der Einschaltphase ein erster Bruchteil des Gesamtstroms $I_G$ über den FET M3A und ein zweiter Bruchteil über den FET M3B.

Die Größe der Beiträge zum Gesamtstrom, die über die Devices M3A und M3B fließen, werden einerseits durch vbias1 und andererseits durch die Geometrieparameter der beiden Devices bestimmt. Je größer das Verhältnis der Breite W zur Länge L (W/L) eines MOSFETs ist, desto mehr Strom fließt bei gegebener Gate-Spannung über die Source-Drain-Strecke dieses Devices. Der während der Einschaltphase durch das Device M3A fließende Strom wird daher durch das W/L-Verhältnis des Devices M3A festgelegt, während der Strom durch M3B durch das W/L-Verhältnis von M3B bestimmt ist.

In der Ausschaltphase befindet sich das Schalttaktsignal clk auf 0, während das invertierte Schalttaktsignal clkn auf 1 liegt. In der Ausschaltphase sperrt daher das Device M3D, während das Device M3C leitet. Das Gate des p-FETs M3B liegt über das Device M3C auf VDD und befindet sich daher im gesperrten Zustand. In der Ausschaltphase des Schalttakts fließt daher kein Strom über M3B; der gesamte während der Ausschaltphase fließende Strom fließt über das Device M3A.

Das Verhältnis des steuerbaren Stroms durch M3B zum konstanten Strom durch M3A kann über das jeweilige W/L der beiden Devices und, falls die Länge L konstant gehalten wird, über das Verhältnis der Breiten W eingestellt werden. Die Breiten W(M3A) und W(M3B) lassen sich mit Hilfe der Split-Faktoren spl1 und spl2 zur Breite von M3 aus Fig. 1 in Verbindung setzen:

$$W(M3A) = W(M3) \cdot spl1$$

$$W(M3B) = W(M3) \cdot spl2$$

wobei die Split-Faktoren spl1 und spl2 Werte zwischen 0 und 1 annehmen können. Soll der modifizierte Operationsverstärker gemäß Fig. 3 in der Einschaltphase das gleiche Verhalten wie der Operationsverstärker in Fig. 1 haben, so muß gelten spl1 + spl2 = 1.

Je größer spl2 im Vergleich zu spl1 gewählt wird, desto größer wird der schaltbare Stromanteil im Vergleich zum Konstantstromanteil, und desto stärker wird der Strom während der Ausschaltphase verringert. Es empfiehlt sich aber, auch während der Ausschaltphase einen gewissen Mindeststrom durch die Vorstufe aufrechtzuerhalten, da sich andernfalls das Einschaltverhalten verschlechtert. Insofern stellt das Verhältnis von spl1 und spl2 einen Kompromiß von Einschaltverhalten und Stromersparnis dar.

Ist der Quotient von spl1 zu spl2 z.B. 1:3, so wird die Stromaufnahme der Eingangsstufe in der Aus-Phase des Operationsverstärkers auf $\dfrac{1}{4}$ reduziert. Bei Betrachtung beider Taktphasen ergibt sich bei einem Tastverhältnis von 50% eine Leistungsersparnis auf ca. $\dfrac{5}{8}$.

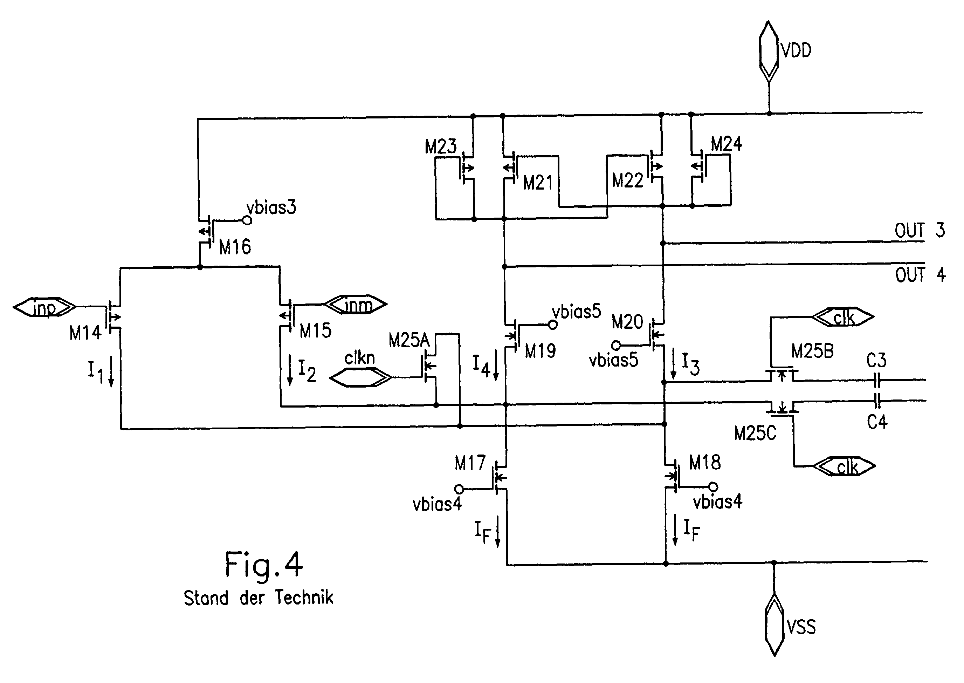

Fig. 4 zeigt eine aus dem Stand der Technik bekannte gefaltete Vorstufe, welche einen Eingangszweig mit den FETs M14, M15 und M16, sowie einen Ausgangszweig mit den FETs M17 bis M24 aufweist. Die Eingangssignale inp und inm liegen an den Gates der Devices M14 und M15 an und bestimmen, wie sich der durch M16 und vbias3 festgelegte Gesamtstrom auf die Ströme $I_1$ und $I_2$ aufteilt. Die Transistoren M17 und M18, an deren Gates jeweils die Vorspannung vbias4 anliegt, wirken jeweils als Konstantstromregler; durch sie fließt jeweils der Strom $I_F$. Wenn man von dem konstanten Strom $I_F$ den sich ändernden Strom $I_1$ abzieht, erhält man den Strom $I_3$. Entsprechend erhält man den Strom $I_4$, indem man vom Konstantstrom $I_F$ den sich ändernden Strom $I_2$ abzieht. Die Ströme im Eingangszweig werden also jeweils eins zu eins in den Ausgangszweig der gefalteten Vorstufe abgeleitet.

Die Ströme $I_3$ und $I_4$ werden über die aus den Devices M21 bis M24 bestehende nichtlineare Last und die Kaskodestufe (Devices M19, M20) in die Ausgangsspannungssignale OUT3 und OUT4 umgewandelt. Diese Ausgangsspannungssignale werden dann der Endstufe des Operationsverstärkers zugeführt.

Eine gefaltete Vorstufe ist insbesondere bei niedrigen Versorgungsspannungen von Vorteil, denn die Faltung des Strompfads erlaubt eine bessere Ausnutzung der Spannung. Trotz geringer Versorgungsspannung kann eine hohe Verstärkung erzielt werden.

Der FET M25A dient zum Schutz der Vorstufe vor Sättigung. Die FETs M25B, M25C verhindern während der Ausschaltphase eine Entladung der Kondensatoren C3, C4, damit das Einschwingverhalten nicht beeinträchtigt wird.

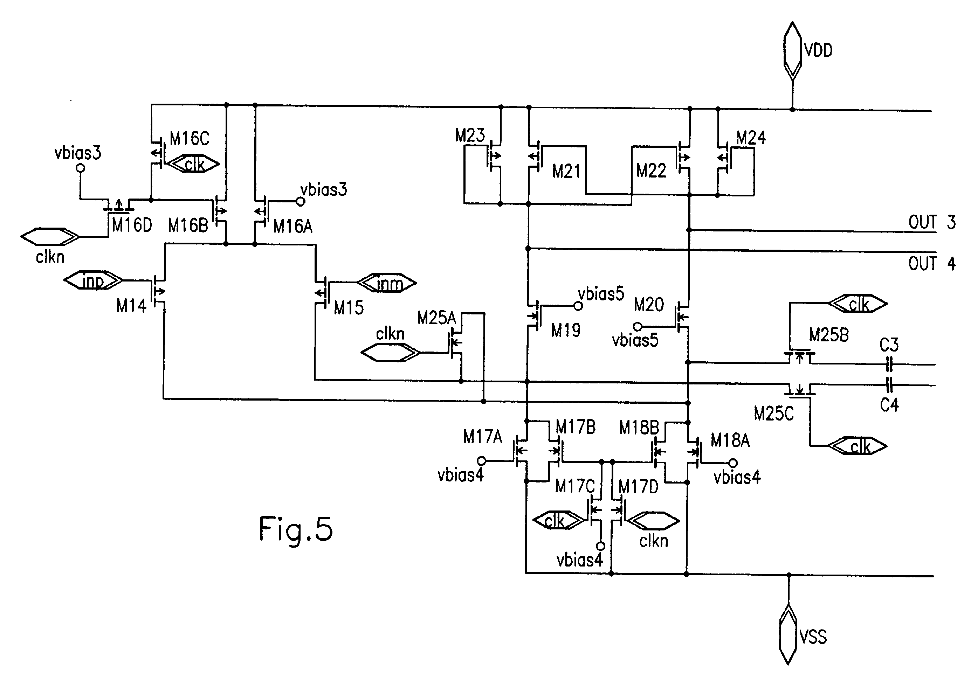

In Fig. 5 ist eine erfindungsgemäß modifizierte gefaltete Vorstufe dargestellt. Die als Stromquellen dienenden Transistoren (M16, M17, M18 in Fig. 4) werden jeweils in die Devices M16A, M16B, M17A, M17B, M18A, M18B gesplittet. Durch die Transistoren M16A, M17A und M18A fließt jeweils ständig ein konstanter Strom. Durch die parallel geschalteten Transistoren M16B, M17B und M18B fließt zusätzlich ein Stromanteil, der erfindungsgemäß während der Aus-Phase des Schalttakts abgeschaltet wird. Bei der in Fig. 5 gezeigten Lösung wird während der Aus-Phase des Schalttakts sowohl der Strom durch den Eingangszweig als auch der Strom durch den Ausgangszweig der Vorstufe des Operationsverstärkers reduziert. Es ist aber auch möglich, nur den Strom im Eingangszweig, bzw. nur den Strom im Ausgangszweig schaltbar auszuführen.

Bei der in Fig. 5 gezeigten Lösung leitet das Device M16D während der Anschaltphase des Schalttaktsignals, das Device M16C dagegen befindet sich im gesperrten Zustand. Deshalb liegt am Gate des p-MOSFETs M16B die Spannung vbias3 an, und M16B leitet. In der Anschaltphase des Schalttaktsignals trägt daher sowohl der Stromfluß durch M16A als auch durch M16B zum Gesamtstrom bei.

In der Aus-Phase des Schalttakts sperrt der FET M16D, während der FET M16C leitet. Das Gate des Device M16B liegt über M16C auf VDD, das Device M16B sperrt daher. Der insgesamt fließende Strom wird so auf den durch M16A fließenden Strombeitrag reduziert.

Ähnlich funktioniert die Stromregelung in der gefalteten Stufe. Der Konstantstromanteil fließt hier über die Devices M17A und M18A, während der Stromanteil durch die Devices M17B und M18B abschaltbar ist. Solange das Schalttaktsignal clk auf 1 ist, leitet der n-MOSFET M17C; der n-MOSFET M17D dagegen sperrt. Daher liegen die Gates der beiden Devices M17B und M18B auf vbias4, und die Devices M17B und M18B tragen zum Gesamtstrom bei. Wenn das Schalttaktsignal dagegen auf 0 liegt, dann sind die Gates der Devices M17B und M18B über M17D mit VSS verbunden, und es fließt kein Strom durch M17B und M18B.

Das Verhältnis des konstanten Stroms zum steuerbaren Strom kann bei konstant gehaltener Länge L über die Breite W der Devices festgelegt werden. Mit Hilfe der Split-Faktoren spl1 und spl2 kann man die Breite der gesplitteten Devices auf die Breite der in Fig. 4 gezeigten Devices beziehen:

$$W(M16A) \ = \ W(M16) \cdot spl1$$

$$W(M16B) \ = \ W(M16) \cdot spl2$$

$$W(M17A) \ = \ W(M17) \cdot spl1$$

$$W(M17B) = W(M17) \cdot spl2$$

$$W(M18A) = W(M18) \cdot spl1$$

$$W(M18B) = W(M18) \cdot spl2$$

Die Split-Faktoren spll und spl2 können dabei Werte zwischen 0 und 1 annehmen. Wenn spll + spl2 = 1 gilt, dann hat die modifizierte Vorstufe während der Einschaltphase das gleiche Verhalten wie die in Fig. 4 gezeigte Vorstufe. Je größer spl2 gewählt wird, desto größer ist die Stromersparnis.

## Patentansprüche

1. Schaltbarer Operationsverstärker für die Switched-Opamp-Technik mit einer Vorstufe und einer Endstufe, wobei die Endstufe durch ein Schalttaktsignal (clk) periodisch ein- und ausschaltbar ist, **gekennzeichnet durch** Mittel zur Reduzierung des Stroms **durch** die Vorstufe, welche den **durch** die Vorstufe fließenden Strom während der Aus-Phase des Schalttaktsignals von einem ersten Wert auf einen kleineren zweiten Wert herabsetzen.

2. Schaltbarer Operationsverstärker nach Anspruch 1, **dadurch gekennzeichnet,** **daß** die Mittel zur Reduzierung des Stroms durch die Vorstufe den durch die Vorstufe fließenden Strom während der Aus-Phase des Schalttaktsignals abschalten.

3. Schaltbarer Operationsverstärker nach Anspruch 2, **dadurch gekennzeichnet,** **daß** die Mittel zur Reduzierung des Stroms durch die Vorstufe mindestens einen Transistor umfassen, der den durch die Vorstufe fließenden Strom während der Aus-Phase des Schalttaktsignals abschaltet.

4. Schaltbarer Operationsverstärker nach Anspruch 1, **dadurch gekennzeichnet,**

   - **daß** die Mittel zur Reduzierung des Stroms durch die Vorstufe mindestens ein Paar parallel geschalteter Transistoren (M3A, M3B) umfassen,
   - wobei während der Einschaltphase des Schalttaktsignals ein erster Bruchteil des durch die Vorstufe fließenden Stroms durch die jeweiligen ersten Transistoren (M3A) des Paars bzw. der Paare fließt und ein zweiter Bruchteil des durch die Vorstufe fließenden Stroms durch die jeweiligen zweiten Transistoren (M3B) des Paars bzw. der Paare fließt, und
   - wobei während der Aus-Phase des Schalttaktsignals die jeweiligen zweiten Transistoren (M3B) abgeschaltet sind.

5. Schaltbarer Operationsverstärker nach einem der vorhergehenden Ansprüche, **dadurch gekennzeichnet,** **daß** die Vorstufe als gefaltete Vorstufe ausgeführt ist, welche einen Eingangszweig und einen Ausgangszweig umfaßt, und **daß** die Mittel zur Reduzierung des Stroms durch die Vorstufe den im Eingangszweig fließenden Strom und/oder den im Ausgangszweig fließenden Strom während der Aus-Phase des Schalttaktsignals herabsetzen.

6. Schaltbarer Operationsverstärker nach Anspruch 5, **dadurch gekennzeichnet,**

   - **daß** der Eingangszweig der Vorstufe mindestens ein Paar parallel geschalteter Transistoren (M16A, M16B) umfaßt,
   - wobei während der Einschaltphase des Schalttaktsignals ein erster Bruchteil des durch den Eingangszweig fließenden Stroms durch die jeweiligen ersten Transistoren (M16A) des Paars bzw. der Paare fließt und ein zweiter Bruchteil des durch den Eingangszweig fließenden Stroms durch die jeweiligen zweiten Transistoren (M16B) des Paars bzw. der Paare fließt, und
   - wobei während der Aus-Phase des Schalttaktsignals die jeweiligen zweiten Transistoren (M16B) abgeschaltet sind.

7. Schaltbarer Operationsverstärker nach einem der Ansprüche 5 oder 6, **dadurch gekennzeichnet,**

   - **daß** der Ausgangszweig der Vorstufe mindestens ein Paar parallel geschalteter Transistoren (M17A, M17B, M18A, M18B) umfaßt,
   - wobei während der Einschaltphase des Schalttaktsignals ein erster Bruchteil des durch den Ausgangszweig fließenden Stroms durch die jeweiligen ersten Transistoren (M17A, M18A) des Paars bzw. der Paare fließt und ein zweiter Bruchteil des durch den Ausgangszweig fließenden Stroms durch die jeweiligen zweiten Transistoren (M17B, M18B) des Paars bzw. der Paare fließt, und
   - wobei während der Aus-Phase des Schalttaktsignals die jeweiligen zweiten Transistoren (M17B, M18B) abgeschaltet sind.

**8.** Schaltbarer Operationsverstärker nach einem der vorhergehenden Ansprüche, **dadurch gekennzeichnet,** **daß** die Mittel zur Reduzierung des Stroms den durch die Vorstufe fließenden Strom bereits vor Beginn der Einschaltphase des Schalttaktsignals von dem kleineren zweiten Wert auf den ersten Wert heraufsetzen.

**9.** Verfahren zum Betrieb eines schaltbaren Operationsverstärkers, wobei der schaltbare Operationsverstärker eine Vorstufe sowie eine Endstufe umfaßt, und wobei die Endstufe durch ein Schalttaktsignal (clk) periodisch ein- und ausgeschaltet wird, **gekennzeichnet durch** folgenden Schritt: Herabsetzen des **durch** die Vorstufe fließenden Stroms während der Aus-Phase des Schalttaktsignals von einem ersten Wert auf einen kleineren zweiten Wert.

**10.** Verfahren nach Anspruch 9, **dadurch gekennzeichnet,** **daß** der durch die Vorstufe fließende Strom während der Aus-Phase des Schalttaktsignals abgeschaltet wird.

**11.** Verfahren nach Anspruch 10, **dadurch gekennzeichnet,** **daß** der durch die Vorstufe fließende Strom über einen Transistor fließt, der während der Aus-Phase des Schalttaktsignals ausgeschaltet wird.

**12.** Verfahren nach Anspruch 9, **dadurch gekennzeichnet,**

- **daß** die Vorstufe mindestens ein Paar parallel geschalteter Transistoren (M3A, M3B) umfaßt,
- wobei während der Einschaltphase des Schalttaktsignals ein erster Bruchteil des durch die Vorstufe fließenden Stroms durch die jeweiligen ersten Transistoren (M3A) des Paars bzw. der Paare fließt und ein zweiter Bruchteil des durch die Vorstufe fließenden Stroms durch die jeweiligen zweiten Transistoren (M3B) des Paars bzw. der Paare fließt, und
- wobei während der Aus-Phase des Schalttaktsignals die jeweiligen zweiten Transistoren (M3B) abgeschaltet werden.

**13.** Verfahren nach einem der Ansprüche 9 bis 12, **dadurch gekennzeichnet,** **daß** die Vorstufe als gefaltete Vorstufe ausgeführt ist, welche einen Eingangszweig und einen Ausgangszweig umfaßt, und **daß** während der Aus-Phase des Schalttaktsignals der im Eingangszweig fließende Strom und/oder der im Ausgangszweig fließende Strom herabgesetzt werden.

**14.** Verfahren nach Anspruch 13, **dadurch gekennzeichnet,**

- **daß** der Eingangszweig der Vorstufe mindestens ein Paar parallel geschalteter Transistoren (M16A, M16B) umfaßt,
- wobei während der Einschaltphase des Schalttaktsignals ein erster Bruchteil des durch den Eingangszweig fließenden Stroms durch die jeweiligen ersten Transistoren (M16A) des Paars bzw. der Paare fließt und ein zweiter Bruchteil des durch den Eingangszweig fließenden Stroms durch die jeweiligen zweiten Transistoren (M16B) des Paars bzw. der Paare fließt, und
- wobei während der Aus-Phase des Schalttaktsignals die jeweiligen zweiten Transistoren (M16B) abgeschaltet werden.

**15.** Verfahren nach einem der Ansprüche 13 oder 14, **dadurch gekennzeichnet,**

- **daß** der Ausgangszweig der Vorstufe mindestens ein Paar parallel geschalteter Transistoren (M17A, M17B, M18A, M18B) umfaßt,
- wobei während der Einschaltphase des Schalttaktsignals ein erster Bruchteil des durch den Ausgangszweig fließenden Stroms durch die jeweiligen ersten Transistoren (M17A, M18A) des Paars bzw. der Paare fließt und ein zweiter Bruchteil des durch den Ausgangszweig fließenden Stroms durch die jeweiligen zweiten Transistoren (M17B, M18B) des Paars bzw. der Paare fließt, und
- wobei während der Aus-Phase des Schalttaktsignals die jeweiligen zweiten Transistoren (M17B, M18B) abgeschaltet werden.

**16.** Verfahren nach einem der Ansprüche 9 bis 15, **dadurch gekennzeichnet,** **daß** der durch die Vorstufe fließende Strom bereits vor Beginn der Einschaltphase des Schalttaktsignals von dem kleineren zweiten Wert auf den ersten Wert heraufgesetzt wird.

**Claims**

**1.** Switched operational amplifier for switched op-amp technology, comprising an input stage and an output stage, wherein the output stage can be switched on and off periodically by a cyclic switching signal (clk), **characterized by** means for reducing the current through the input stage, which reduce the current flowing through the input stage from a first value to a smaller second value during the off phase of the cyclic switching signal.

**2.** Switched operational amplifier according to Claim 1,

**characterized in that** the means for reducing the current through the input stage switch off the current flowing through the input stage during the off phase of the cyclic switching signal.

3. Switched operational amplifier according to Claim 2, **characterized in that** the means for reducing the current through the input stage comprise at least one transistor which switches off the current flowing through the input stage during the off phase of the cyclic switching signal.

4. Switched operational amplifier according to Claim 1, **characterized in that**

   - the means for reducing the current through the input stage comprise at least one pair of transistors (M3A, M3B) connected in parallel,
   - wherein a first fraction of the current flowing through the input stage flows through the respective first transistors (M3A) of the pair or of the pairs, respectively, and a second fraction of the current flowing through the input stage flows through the respective second transistors (M3B) of the pair or of the pairs, respectively, during the on phase of the cyclic switching signal, and
   - wherein the respective second transistors (M3B) are switched off during the off phase of the cyclic switching signal.

5. Switched operational amplifier according to one of the preceding claims, **characterized in that** the input stage is constructed as a folded input stage which comprises an input branch and an output branch, and **in that** the means for reducing the current through the input stage reduce the current flowing in the input branch and/or the current flowing in the output branch during the off phase of the cyclic switching signal.

6. Switched operational amplifier according to Claim 5, **characterized in that**

   - the input branch of the input stage comprises at least one pair of transistors (M16A, M16B) connected in parallel,
   - wherein a first fraction of the current flowing through the input branch flows through the respective first transistors (M16A) of the pair or of the pairs, respectively, and a second fraction of the current flowing through the input branch flows through the respective second transistors (M16B) of the pair or of the pairs, respectively, during the on phase of the cyclic switching signal, and
   - wherein the respective second transistors (M16B) are switched off during the off phase of the cyclic switching signal.

7. Switched operational amplifier according to one of Claims 5 or 6, **characterized in that**

   - the output branch of the input stage comprises at least one pair of transistors (M17A, M17B, M18A, M18B) connected in parallel,
   - wherein a first fraction of the current flowing through the output branch flows through the respective first transistors (M17A, M18A) of the pair or of the pairs, respectively, and a second fraction of the current flowing through the output branch flows through the respective second transistors (M17B, M18B) of the pair or of the pairs, respectively, during the on phase of the cyclic switching signal, and
   - wherein the respective second transistors (M17B, M18B) are switched off during the off phase of the cyclic switching signal.

8. Switched operational amplifier according to one of the preceding claims, **characterized in that** the means for reducing the current increase the current flowing through the input stage from the smaller second value to the first value even before the beginning of the on phase of the cyclic switching signal.

9. Method for operating a switched operational amplifier, wherein the switched operational amplifier comprises an input stage and an output stage and wherein the output stage is switched on and off periodically by a cyclic switching signal (clk), **characterized by** the following step: reducing the current flowing through the input stage from a first value to a smaller second value during the off phase of the cyclic switching signal.

10. Method according to Claim 9, **characterized in that** the current flowing through the input stage is switched off during the off phase of the cyclic switching signal.

11. Method according to Claim 10, **characterized in that** the current flowing through the input stage flows via a transistor which is switched off during the off phase of the cyclic switching signal.

12. Method according to Claim 9, **characterized in that**

   - the input stage comprises at least one pair of transistors (M3A, M3B) connected in parallel,
   - wherein a first fraction of the current flowing through the input stage flows through the respective first transistors (M3A) of the pair or of the pairs, respectively, and a second fraction of the current flowing through the input stage flows through the respective second transistors (M3B) of the pair or of the pairs, respectively, during the on phase of the cyclic switching signal, and

- wherein the respective second transistors (M3B) are switched off during the off phase of the cyclic switching signal.

13. Method according to one of Claims 9 to 12, **characterized in that** the input stage is constructed as a folded input stage which comprises an input branch and an output branch, and **in that** the current flowing in the input branch and/or the current flowing in the output branch are reduced during the off phase of the cyclic switching signal.

14. Method according to Claim 13, **characterized in that**

- the input branch of the input stage comprises at least one pair of transistors (M16A, M16B) connected in parallel,
- wherein a first fraction of the current flowing through the input branch flows through the respective first transistors (M16A) of the pair or of the pairs, respectively, and a second fraction of the current flowing through the input branch flows through the respective second transistors (M16B) of the pair or of the pairs, respectively, during the on phase of the cyclic switching signal, and
- wherein the respective second transistors (M16B) are switched off during the off phase of the cyclic switching signal.

15. Method according to one of Claims 13 or 14, **characterized in that**

- the output branch of the input stage comprises at least one pair of transistors (M17A, M17B, M18A, M18B) connected in parallel,
- wherein a first fraction of the current flowing through the output branch flows through the respective first transistors (M17A, M18A) of the pair or of the pairs, respectively, and a second fraction of the current flowing through the output branch flows through the respective second transistors (M17B, M18B) of the pair or of the pairs, respectively, during the on phase of the cyclic switching signal, and
- wherein the respective second transistors (M17B, M18B) are switched off during the off phase of the cyclic switching signal.

16. Method according to one of Claims 9 to 15, **characterized in that** the current flowing through the input stage is increased from the smaller second value to the first value even before the beginning of the on phase of the cyclic switching signal

**Revendications**

1. Amplificateur opérationnel commutable pour la technique Switched-Opamp comprenant un étage préliminaire et un étage final, l'étage final pouvant être branché et débranché périodiquement par un signal (clk) de cadencement de commutation,
   **caractérisé**
   **par** des moyens de réduction du courant par l'étage préliminaire qui abaissent le courant passant dans l'étage préliminaire d'une première valeur à une deuxième valeur plus petite pendant la phase de débranchement du signal de cadencement de commutation.

2. Amplificateur opérationnel commutable suivant la revendication 1,
   **caractérisé**
   **en ce que** les moyens de réduction du courant par l'étage préliminaire interrompent le courant passant dans l'étage préliminaire pendant la phase de débranchement du signal de cadencement de commutation.

3. Amplificateur opérationnel commutable suivant la revendication 2,
   **caractérisé**
   **en ce que** les moyens de réduction du courant passant dans l'étage préliminaire comprennent au moins un transistor qui interrompt le courant passant dans l'étage préliminaire pendant la phase de débranchement du signal de cadencement de commutation.

4. Amplificateur opérationnel commutable suivant la revendication 1,
   **caractérisé**

   - **en ce que** les moyens de réduction du courant par l'étage préliminaire comprennent au moins une paire de transistors (M3A, M3B) montés en parallèle,
   - dans lequel, pendant la phase de branchement du signal de cadencement de commutation, une première fraction du courant passant dans l'étage préliminaire passe dans les premiers transistors (M3A) de la paire ou des paires et une deuxième fraction du courant passant dans l'étage préliminaire passe dans les deuxièmes transistors (M3B) de la paire ou des paires et
   - dans lequel, pendant la phase de débranchement du signal de cadencement de commutation, les deuxièmes transistors (M3B) sont mis hors circuit.

5. Amplificateur opérationnel commutable suivant l'une des revendications précédentes,
   **caractérisé**

**en ce que** l'étage préliminaire est réalisé en étage préliminaire plié qui comprend une branche d'entrée et une branche de sortie et en ce que les moyens de réduction du courant par l'étage préliminaire abaissent le courant passant dans la branche d'entrée et/ou le courant passant dans la branche de sortie pendant la phase de débranchement du signal de cadencement de commutation.

6. Amplificateur opérationnel commutable suivant la revendication 5,
**caractérisé**

- **en ce que** la branche d'entrée de l'étage préliminaire comprend au moins une paire de transistors (M16A, M16B) montés en parallèle,
- dans lequel, pendant la phase de branchement du signal de cadencement de commutation, une première fraction du courant passant dans la branche d'entrée passe dans les premiers transistors (M16A) de la paire ou des paires et une deuxième fraction du courant passant dans la branche d'entrée passe dans les deuxièmes transistors (M16B) de la paire ou des paires et
- dans lequel, pendant la phase de débranchement du signal de cadencement de commutation, les deuxièmes transistors (M16B) sont mis hors circuit.

7. Amplificateur opérationnel commutable suivant l'une des revendications 5 ou 6,
**caractérisé**

- **en ce que** la branche de sortie de l'étage préliminaire comprend au moins une paire de transistors (M17A, M17B, M18A, M18B) montés en parallèle,
- dans lequel, pendant la phase de branchement du signal de cadencement de commutation, une première fraction du courant passant dans la branche de sortie passe dans les premiers transistors (M17A, M18A) de la paire ou des paires et une deuxième fraction du courant passant dans la branche de sortie passe dans les deuxièmes transistors (M17B, M18B) de la paire ou des paires et
- dans lequel, pendant la phase de débranchement du signal de cadencement de commutation, les deuxièmes transistors (M17B, M18B) sont mis hors circuit.

8. Amplificateur opérationnel commutable suivant l'une des revendications précédentes,
**caractérisé**
**en ce que** les moyens de réduction du courant élèvent de la deuxième valeur plus petite à la première valeur le courant passant dans l'étage préliminaire dès avant le début de la phase de branchement du signal de cadencement de commutation.

9. Procédé pour faire fonctionner un amplificateur opérationnel commutable,
dans lequel l'amplificateur opérationnel commutable comprend un étage préliminaire et un étage final et l'étage final étant branché ou débranché périodiquement par un signal (clk) de cadencement de commutation,
**caractérisé par** le stade suivant :

abaissement du courant passant dans l'étage préliminaire pendant la phase de débranchement du signal de cadencement de commutation d'une première valeur à une deuxième valeur plus petite.

10. Procédé suivant la revendication 9,
**caractérisé**
**en ce que** l'on interrompt le courant passant dans l'étage préliminaire pendant la phase de débranchement du signal de cadencement de commutation.

11. Procédé suivant la revendication 10,
**caractérisé**
**en ce que** le courant passant dans l'étage préliminaire passe par un transistor qui est mis hors circuit par la phase de débranchement du signal de cadencement de commutation.

12. Procédé suivant la revendication 9,
**caractérisé**

- **en ce que** l'étage préliminaire comprend au moins une paire de transistors (M3A, M3B) montés en parallèle,
- dans lequel, pendant la phase de branchement du signal de cadencement de commutation, une première fraction du courant passant dans l'étage préliminaire passe dans les premiers transistors (M3A) de la paire ou des paires et une deuxième fraction du courant passant dans l'étage préliminaire passe dans les deuxièmes transistors (M3B) de la paire ou des paires et
- dans lequel, pendant la phase de débranchement du signal de cadencement de commutation, les deuxièmes transistors (M3B) sont mis hors circuit.

13. Procédé suivant l'une des revendications 9 à 12,
**caractérisé**
**en ce que** l'étage préliminaire est réalisé en étage préliminaire plié qui comprend une branche d'entrée et une branche de sortie et en ce que les moyens de réduction du courant par l'étage préliminaire abaissent le courant passant dans la branche d'entrée et/ou le courant passant dans la branche de sortie pendant la phase de débranchement du signal de cadencement de commutation.

14. Procédé suivant la revendication 13, **caractérisé**

- **en ce que** la branche d'entrée de l'étage préliminaire comprend au moins une paire de transistors (M16A, M16B) montés en parallèle,
- dans lequel, pendant la phase de branchement du signal de cadencement de commutation, une première fraction du courant passant dans la branche d'entrée passe dans les premiers transistors (M16A) de la paire ou des paires et une deuxième fraction du courant passant dans la branche d'entrée passe dans les deuxièmes transistors (M16B) de la paire ou des paires et
- dans lequel, pendant la phase de débranchement du signal de cadencement de commutation, les deuxièmes transistors (M16B) sont mis hors circuit.

15. Procédé suivant l'une des revendications 13 ou 14, **caractérisé**

- **en ce que** la branche de sortie de l'étage préliminaire comprend au moins une paire de transistors (M17A, M17B, M18A, M18B) montés en parallèle,
- dans lequel, pendant la phase de branchement du signal de cadencement de commutation, une première fraction du courant passant dans la branche de sortie passe dans les premiers transistors (M17A, M18A) de la paire ou des paires et une deuxième fraction du courant passant dans la branche de sortie passe dans les deuxièmes transistors (M17B, M18B) de la paire ou des paires et
- dans lequel, pendant la phase de débranchement du signal de cadencement de commutation, les deuxièmes transistors (M17B, M18B) sont mis hors circuit.

16. Procédé suivant l'une des revendications 9 à 15, **caractérisé**
**en ce que** le courant passant dans l'étage préliminaire est élevé de la deuxième valeur plus petite à la première valeur dès avant le début de la phase de branchement du signal de cadencement de commutation.

VDD

$I_G$

M3

inp

M1

$I_+$

clkn

M10A

$I_-$

M2

inm

clk

M10B

C1

M10C

C2

clk

vbias2

M4

M5

vbias2

OUT 1

OUT 2

M8

M6

M7

M9

VSS

# Fig.1

Stand der Technik

Fig.2

Stand der Technik

Fig.3

Fig. 4
Stand der Technik

Fig.5

16